**Europäisches Patentamt**

**European Patent Office**

**Office européen des brevets**

(19)

(11) Veröffentlichungsnummer: **0 262 439 B1**

## (12) EUROPÄISCHE PATENTSCHRIFT

(45) Veröffentlichungstag der Patentschrift: **17.02.93**

(21) Anmeldenummer: **87112826.0**

(22) Anmeldetag: **02.09.87**

(51) Int. Cl.⁵: **H01S 3/085**, G02B 6/28, H04B 10/04

(54) **Lasersender mit einem Halbleiterlaser und einem externen Resonator.**

(30) Priorität: **29.09.86 DE 3633076**

(43) Veröffentlichungstag der Anmeldung:
**06.04.88 Patentblatt 88/14**

(45) Bekanntmachung des Hinweises auf die
Patenterteilung:
**17.02.93 Patentblatt 93/07**

(84) Benannte Vertragsstaaten:
**AT BE CH DE ES FR GB GR IT LI NL SE**

(56) Entgegenhaltungen:
**EP-A- 0 182 033**

**APPLIED PHYSICS LETTERS, Band 49, Nr. 1,
7. Juli 1986, Seiten 10-12, American Institute
of Physics, New York, US; S.K. KOROTKY et
al.: "Integrated-optic, narrow-linewidth laser"**

**IDEM**

(73) Patentinhaber: **SIEMENS AKTIENGESELL-
SCHAFT
Wittelsbacherplatz 2
W-8000 München 2(DE)**

(72) Erfinder: **Häussler, Klaus-M., Dr.
Hildebrandstrasse 13
W-8000 Münche 19(DE)**
Erfinder: **Wittmann, Julius, Dipl.-Ing.(FH)
Innerer Stockweg 7
W-8024 Oberhaching(DE)**
Erfinder: **Gaukel, Gisela, Dipl.-Phys.
Görrestrasse 17
W-8000 München 40(DE)**
Erfinder: **Auracher, Franz, Dr.
Eichenstrasse 26
W-8021 Baierbrunn(DE)**

## Beschreibung

Die vorliegende Erfindung betrifft einen Lasersender mit einem Halbleiterlaser und einem externen Resonator in Form eines optischen Richtkopplers, bei dem die Ausgangsstrahlung aus dem Resonator entnommen wird, der eine Wellenlängenselektivität des Senders bewirkt.

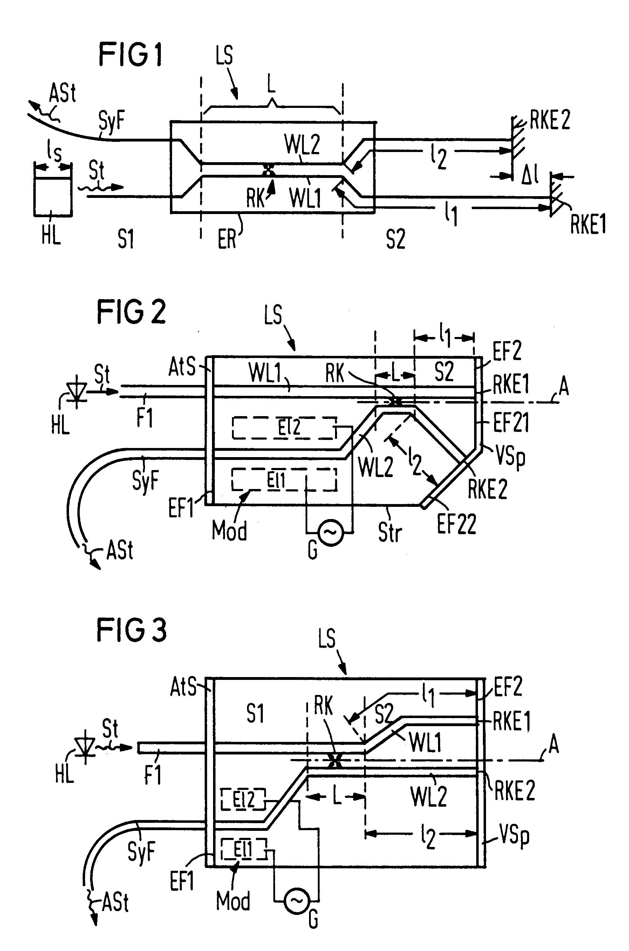

Ein Sender der genannten Art ist aus Appl. Phys. Lett., Bd. 49, Nr. 1, Juli 1986, S. 10 bis 12 bekannt und in der nicht vorveröffentlichten europäischen Patentanmeldung mit älterem Zeitrang vorgeschlagen (siehe dort Figur 2 und dazugehörigen Beschreibungsteil).

Bei dem einen bekannten Sender ist dem einen Wellenleiter, dem die Rückkopplungseinrichtung zugeordnet ist eine weitere Rückkopplungseinrichtung zugeordnet, wobei die eine Rückkopplungseinrichtung und die weitere Rückkopplungseinrichtung an einander entgegengesetzten Enden dieses einen Wellenleiters angeordnet sind.

Bei dem anderen vorgeschlagenen Sender ist die dem einen optischen Wellenleiter zugeordnete Rückkopplungseinrichtung teildurchlässig und der durch die Rückkopplungseinrichtung hindurchgegangene Teil der Strahlungsleistung wird über einen schleifenförmigen optischen Wellenleiter dem anderen optischen Wellenleiter auf der einen Seite der Koppelstrecke zugeführt, auf welcher der Halbleiterlaser angeordnet ist.

Mit einem derartigen vorgeschlagenen Lasersender kann ein extrem schmalbandiger, einmodiger Betriebszustand erreicht werden, wie er für zukünftige faseroptische Nachrichtensysteme, insbesondere mit Heterodyn- und Homodynempfang erforderlich ist.

Ein derartiger vorgeschlagener Lasersender weist den Vorteil auf, daß die Ankopplung des Resonators und einer Systemfaser an den Halbleiterlaser auf nur einer Seite des Halbleiterlasers erfolgt, im Gegensatz zu anderen Ausführungsformen solcher Lasersender, bei denen die Systemfaser auf einer Seite und der Resonator auf der gegenüberliegenden Seite an den Halbleiterlaser angekoppelt sind. Durch die einseitige Ankopplung werden Justierprobleme erheblich vermindert und es kann dem Erfordernis einer hohen mechanischen Stabilität bei der Ankopplung der Systemfaser und des externen Resonators besser entsprochen werden.

Aufgabe der Erfindung ist es, einen Lasersender mit einem Halbleiterlaser und einem externen optischen Resonator in Form eines optischen Richtkopplers anzugeben, bei dem ein einmodiger Betrieb dadurch erreicht werden kann, daß dem Modenspektrum des freilaufenden Lasersenders eine Interferenzstruktur überlagert und dabei Nachbarmoden unterdrückt werden können.

Diese Aufgabe wird durch die im Patentanspruch 1 angegebenen Merkmale gelöst.

Der erfindungsgemäße Lasersender stellt ein Analogon zum sogenannten Fox-Smith-Resonator (siehe IEEE J. Quantum Electronics, QE-1 (1965), Seiten 343 ff) dar, der bei klassischen Lasern mit freier Strahlausbreitung eingesetzt wird, um eine Modenselektion zu erreichen. Im Gegensatz zur "klassischen" Anordnung liegt allerdings beim erfindungsgemäßen Lasersender der externe Resonator außerhalb des verstärkenden Mediums, wobei der einmodige Betrieb auf einfachste Weise dadurch erreicht werden kann, daß die im Anspruch 1 angegebenen Maßnahmen ergriffen werden.

Vorteile dieser Ausgestaltung des erfindungsgemäßen Lasersenders sind in folgendem zu sehen:

i) Die erforderlichen optischen Abstände $1_1$ und $1_2$, die in der Regel durch Faser- oder Wellenleiterlängen realisiert sind, und damit die Resonatorkonfiguration lassen sich getrennt vom Halbleiterlaser selbst justieren.

ii) Thermische Einflüsse sind für die Modenunterdrückung wenig entscheidend.

iii) Nur die optischen Abstände zwischen dem Halbleiterlaser und dem optischen Richtkoppler, im allgemeinen durch optische Längen eines Faserstücks realisiert, bzw. die Koppelstrecke L des Richtkopplers selbst müssen stabilisiert werden.

Vorteilhafterweise ist der den optischen Resonator bildende optische Richtkoppler gemäß Anspruch 2 ein wellenlängenselektiver Richtkoppler.

Der optische Richtkoppler kann ein Faserrichtkoppler (Anspruch 3) aber auch ein auf einem Substrat integrierter Richtkoppler sein (Anspruch 4), der beispielsweise durch Herstellung der gekoppelten Wellenleiter mittels eines Ionenaustauschprozesses auf einem Glassubstrat oder durch Eindiffusion von Titan in einem Lithiumniobatkristall erzeugt werden kann.

Bevorzugte Ausführungsformen eines Lasersenders mit einem integriert optischen Richtkoppler gehen aus den übrigen Ansprüchen hervor.

Die Erfindung wird in der folgenden Beschreibung anhand der Figuren prinzipiell und beispielhaft näher erläutert. Von den Figuren zeigen:

Figur 1
schematisch den prinzipiellen Aufbau des Lasersenders mit einseitiger Ankopplung des externen Resonators,

Figuren 2 bis 5
Ausführungsformen eines Lasersenders mit integriert optischem externen Resonator, der an einen separaten Lasersender anzukoppeln ist, und

Figuren 5 und 6
Ausführungsformen eines Lasersenders mit optischem Richtkoppler als externem Resonator in monolithisch integriert-optischer Ausführung.

Der Lasersender LS nach Figur 1 weist einen Halbleiterlaser HL und einen externen optischen Resonator ER auf. Der Resonator ER ist in Form eines optischen Richtkopplers RK ausgebildet, der aus zwei in einer bestimmten Koppelstrecke L in derart geringem Abstand nebeneinander verlaufenden Wellenleitern WL1, WL2 besteht, daß in der Koppelstrecke L eine Strahlungsüberkopplung zwischen den Wellenleitern WL1 und WL2 auftritt.

Der eine Wellenleiter WL1 ist auf einer Seite S1 der Koppelstrecke L an den Halbleiterlaser HL angekoppelt und auf der anderen Seite S2 dieser Strecke L ist eine diesem einen Wellenleiter WL1 zugeordnete Rückkopplungseinrichtung RKE1 vorgesehen, die bewirkt, daß wenigstens ein Teil einer ihr aus dem einen Wellenleiter WL1 zugeleiteten Strahlungsleistung in diesem Wellenleiter WL1 zurück in die Koppelstrecke L geleitet wird.

Auch dem anderen Wellenleiter WL2 ist eine Rückkopplungseinrichtung RKE2 zugeordnet, die beispielsweise auf der anderen Seite S2 der Koppelstrecke L angeordnet ist und bewirkt, daß wenigstens ein Teil einer ihr aus dem anderen Wellenleiter WL2 zugeleiteten Strahlungsleistung in diesem anderen Wellenleiter WL2 zurück in die Koppelstrecke L geleitet wird.

Die Ausgangsleistung ASt des Senders LS wird dem anderen Wellenleiter WL2 auf der einen Seite S1 der Koppelstrecke L entnommen.

Durch die Rückkopplungseinrichtungen RKE1 und RKE2 wird bewirkt, daß die vom Halbleiterlaser emittierte Strahlungsleistung St zum Teil in den Halbleiterlaser HL rückgekoppelt und gleichzeitig, entsprechend dem Teilerverhältnis des Richtkopplers RK, in eine Systemfaser SyF eingespeist werden kann. Dies stellt das genannte Analogon zum genannten Fox-Smith-Resonator dar.

Darüber hinaus unterscheiden sich der optische Abstand $l_1$ zwischen der Koppelstrecke L und der dem einen Wellenleiter WL1 zugeordneten Rückkopplungseinrichtung RKE1 und der optische Abstand $l_2$ zwischen der Koppelstrecke L und der dem anderen Wellenleiter WL2 zugeordneten Rückkopplungseinrichtung RKE2 um eine Abstandsdifferenz $\Delta l$ voneinander, die betragsmäßig in der Größenordnung der Länge $l_s$ des Halbleiterlasers HL liegt. Optischer Abstand zwischen der Koppelstrecke und einer Rückkopplungseinrichtung bedeutet eine bestimmte Laufzeit der Strahlung von der Koppelstrecke zur Rückkopplungseinrichtung und zurück, wobei ein größerer optischer Abstand eine größere Laufzeit bedeutet.

Durch diese Maßnahme kann ein einmodiger Betrieb des Lasers erreicht werden. Dies beruht auf der Tatsache, daß sowohl das effektive Transmissionsvermögen des externen Resonators ER mit den beiden Rückkopplungseinrichtungen RKE1 und RKE2 als auch das die Rückwirkung auf den Halbleiterlaser HL bestimmende effektive, frequenzabhängige Reflexionsvermögen der beiden Rückkopplungseinrichtungen RKE1 und RKE2 einen Interferenztherm enthalten, der zu

$$R_1 . R_2 . \cos (\phi_1 - \phi_2)$$

proportional ist, wobei $R_1$ und $R_2$ effektive Amplitudenreflektivitäten der Rückkopplungseinrichtungen RKE1 bzw. RKE2 und $\phi_1$ und $\phi_2$ die Phasenlage einer Strahlungskomponente nach dem Durchlaufen des optischen Abstandes $l_1$ von der Koppelstrecke L zur einen Rückkopplungseinrichtung RKE1 und zurück bzw. die Phasenlage einer Strahlungskomponente nach dem Durchlaufen des optischen Abstandes $l_2$ von der Koppelstrecke L zur anderen Rückkopplungseinrichtung RKE2 und zurück zur Koppelstrecke L bedeuten.

Dem Modenspektrum des freilaufenden Lasersenders LS, das heißt des ohne die Rückkopplungseinrichtungen RKE1 und RKE2 betriebenen Lasersenders LS wird somit eine Interferenzstruktur überlagert. Die Maxima und Minima dieser Interferenzstruktur haben einen Frequenzabstand von

$$f = c/2n \ (l_1 - l_2),$$

wobei c die Vakuumlichtgeschwindigkeit und n die Brechzahl des strahlungsführenden Mediums zwischen der Koppelstrecke L und den Richtkopplungseinrichtungen RKE1 und RKE2 bedeuten.

Bei geeigneter Längendifferenz $\Delta l = l_1 - l_2$ kann durch Unterdrückung der Nachbarmoden - die Rückwirkung ist frequenzselektiv - ein einmodiger Betrieb des Lasers erreicht werden, wobei die Längendifferenz $\Delta l$ dazu in der Größenordnung der Länge $l_s$ des Halbleiterlasers HL liegen muß.

Bei den integriert optischen Ausführungsformen nach den Figuren 2 bis 6 des Lasersenders LS bestehen die beiden Wellenleiter WL1 und WL2 aus Streifenwellenleitern, die an der Oberfläche eines Substrats Str integriert sind. Diese Oberfläche ist in den Figuren 2 bis 6 in Draufsicht gezeigt.

Das Substrat kann beispielsweise aus Lithiumniobat bestehen. Auf diesem Material wurden bereits Modulator-und Richtkopplerstrukturen realisiert (siehe dazu J. Lightwave Technology LT-3 (1985), Seiten 1 bis 6, J. of Optical Comunn. 5 (1984), Seiten 7 bis 9, oder IEEE J. Quant. Electronics QE 21 (1985), Seiten 1144 bis 1146). Die Streifenwellenleiter werden in diesem Substrat vorzugsweise als diffundierte Wellenleiter ausgeführt.

Bei allen Ausführungsformen nach den Figuren 2 bis 6 verläuft wenigstens der andere Streifenwellenleiter WL2 von einer Endfläche EF1 zu einer anderen Endfläche EF2 des Substrats Str. Diese Endflächen EF1 und EF2 sind senkrecht zur in Draufsicht gezeigten Oberfläche des Substrats Str angeordnet.

Bei den Ausführungsformen nach den Figuren 2 und 3 verläuft auch der eine Streifenwellenleiter WL1 von der einen Endfläche EF1 zur anderen Endfläche EF2. Diese Endflächen EF1 und EF2 und damit auch die in ihnen liegenden Enden der Streifenwellenleiter WL1 und WL2 sind zweckmäßigerweise plan poliert. Die Kopplung der vom Halbleiterlaser HL emittierten Strahlungsleistung St in den einem Streifenwellenleiter WL1 und die Kopplung der Ausgangsleistung ASt aus dem anderen Streifenwellenleiter WL2 in die Systemfaser SyF erfolgt über die auf der einen Seite S1 der Koppelstrecke L der beiden Streifenwellenleiter WL1 und WL2 befindliche Endfläche EF1, auf der zu diesem Zweck eine Antireflexschicht Ats aufgebracht ist. Die Kopplung des Halbleiterlasers HL an den einen Streifenwellenleiter WL1 kann über eine Faser F1 oder über eine nicht dargestellte Optik erfolgen. Die Kopplung der Systemfaser SyF an den anderen Streifenwellenleiter WL2 kann direkt oder ebenfalls über eine nicht dargestellte Optik erfolgen. Die andere Endfläche EF2 des Substrats Str befindet sich auf der anderen Seite S2 der Koppelstrecke L. Die den beiden Streifenwellenleitern WL1 und WL2 zugeordneten Rückkopplungseinrichtungen RKE1 bzw. RKE2 sind durch eine auf diese andere Endfläche EF2 aufgebrachte Verspiegelung Vsp realisiert. Die optischen Abstände $l_1$ und $l_2$ sind durch die Längen der Abschnitte der betreffenden Streifenwellenleiter WL1 bzw. WL2 zwischen der Koppelstrecke L und der anderen Endfläche EF2 bestimmt, die senkrecht an diese andere Endfläche EF2 stoßen.

Die unterschiedlichen optischen Abstände $l_1$ und $l_2$ können auf einfache Weise dadurch erreicht werden, daß die beiden Abschnitte der Streifenwellenleiter WL1 und WL2 zwischen der Koppelstrecke L und der anderen Endfläche EF2 unsymmetrisch zur Mittelachse A des Streifenwellenleiterpaares innerhalb der Koppelstrecke L verlaufen.

Bei der Ausführungsform nach Figur 2 ist diese Unsymmetrie dadurch gegeben, daß der genannte Abschnitt eines Wellenleiters, beispielsweise des Wellenleiters WL1 parallel und der genannte Abschnitt des anderen Wellenleiters WL2 unter einem Winkel zu dieser Mittelachse A geradlinig verläuft und daß die verspiegelte andere Endfläche EF2 derart abgewinkelt ist, daß die beiden genannten Abschnitte senkrecht an unter einem Winkel zueinander stehende Abschnitte EF21 und EF22 der anderen Endfläche EF2 stoßen, die derart angeordnet sind, daß die Längen $l_1$ und $l_2$ der beiden genannten Abschnitte voneinander verschieden sind.

Eine gewinkelte Endfläche kann vermieden werden, wenn ein von der Koppelstrecke L unter einem Winkel zur Mittelachse A des Streifenwellenleiterpaares innerhalb der Koppelstrecke L fortlaufender genannter Abschnitt in einem zu dieser Mittelachse A parallelen Endabschnitt übergeht, der senkrecht an die plane Endfläche EF2 stößt. Eine derartige Ausführungsform ist in der Figur 3 dargestellt.

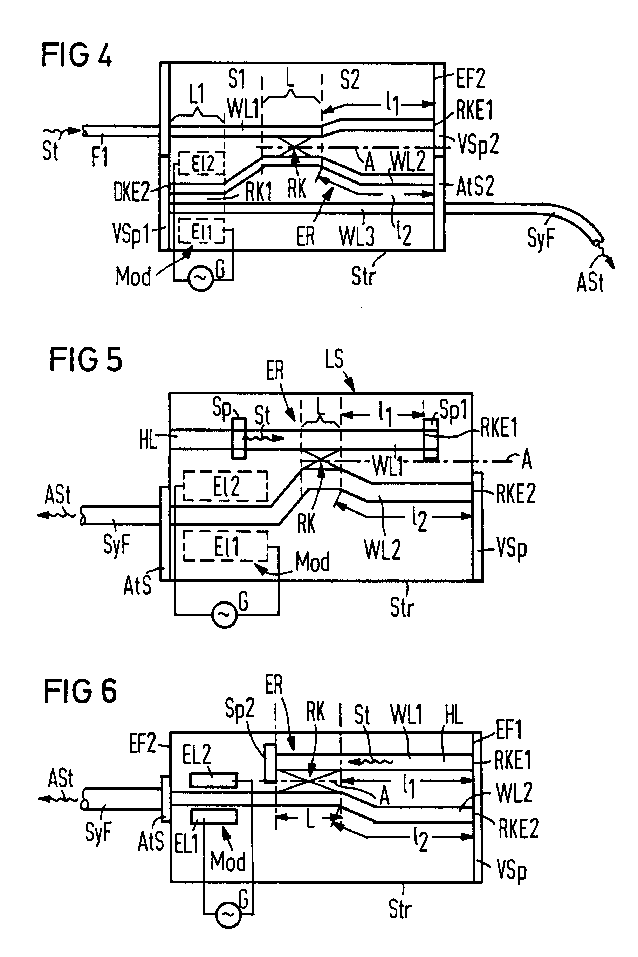

Die Ausführungsform nach Figur 4 unterscheidet sich von den Ausführungsformen nach den Figuren 2 und 3 im wesentlichen dadurch, daß die Strahlungsleistung St des Halbleiterlasers HL über die eine Endfläche EF1 in den einen Streifenwellenleiter WL1 eingekoppelt ist und die dem anderen Streifenwellenleiter WL2 zugeordnete Rückkopplungseinrichtung RKE2 auf dieser einen Endfläche EF1 in Form einer Teilverspiegelung VSp1 dieser einen Endfläche EF1 vorgesehen ist, und daß die dem einen Streifenwellenleiter zugeordnete Rückkopplungseinrichtung RKE1 auf der anderen Endfläche EF2 in Form einer Teilverspiegelung VSp2 vorgesehen ist und die Kopplung der Ausgangsleistung ASt des Senders LS in die Systemfaser SyF an dieser anderen Endfläche EF2 erfolgt. Dazu ist ein im Bereich der Teilverspiegelung VSp1 an den anderen Streifenwellenleiter WL2 gekoppelter Streifenwellenleiter WL3 auf dem Substrat Str vorgesehen, der von der einen Endfläche EF1 zur anderen Endfläche EF2 verläuft.

Die Kopplung des weiteren Streifenwellenleiters WL3 an den anderen Wellenleiter WL2 erfolgt beispielsweise über einen optischen Richtkoppler RK1, der so ausgebildet sein kann wie der eine optische Richtkoppler RK, d. h. in einer bestimmten Koppelstrecke L1 verlaufen der andere Wellenleiter WL2 und der weitere Wellenleiter WL3 in einem so kleinen Abstand nebeneinander, daß eine Leistungsüberkopplung zwischen diesen Wellenleitern stattfindet, wobei die Besonderheit gegeben ist, daß diese Koppelstrecke L1 auf einer Seite mit der Verspiegelung VSp1 versehen ist.

Die Kopplung der Strahlungsleistung St aus dem Halbleiterlaser HL in den einen Streifenwellenleiter WL1 und der Ausgangsleistung ASt aus den weiteren Wellenleiter WL3 in die Systemfaser SyF erfolgt zweckmäßigerweise wieder über Antireflexschichten AtS1 und AtS2, die auf einen Teilbereich der betreffenden Endflächen EF1 bzw. EF2 des Substrats Str aufgebracht sind.

Die integriert optischen Ausführungsformen nach den Figuren 5 und 6 unterscheiden sich von den Ausführungsformen nach den Figuren 2 und 3 im wesentlichen dadurch, daß der Halbleiterlaser HL mit dem externen Resonator monolithisch auf dem Substrat Str integriert ist.

Bei der Ausführungsform nach Figur 5 ist der Halbleiterlaser HL in Form eines Streifenlasers ausgebildet, der über einen geätzten Spiegel Sp oder ein Bragg-Gitter an den einen Streifenwellenleiter WL1 des Resonators ER gekoppelt ist.

Bei der Ausführungsform nach Figur 6 ist der gesamte eine Streifenwellenleiter WL1 des externen Resonators ER als Streifenlaser ausgebildet, der den Halbleiterlaser HL bildet und der den Abschnitt der Länge $L_1$ dieses einen Wellenleiters WL1 zwischen der Koppelstrecke L und der einen Rückkopplungseinrichtung RKE mit umfaßt. Auf der von der einen Rückkopplungseinrichtung KE1 abgekehrten Seite der Koppelstrecke L ist der eine Wellenleiter WL1 durch einen geätzten Spiegel Sp2 oder ein geätztes Bragg-Gitter begrenzt.

Bei Verwendung eines Substrats aus elektrooptischem Material, beispielsweise $LiNbO_3$, können bei allen integriert-optischen Ausführungsformen Modulatoren zur Modulation der Ausgangsleistung des Lasersenders, wie sie beispielsweise bei der optischen Nachrichtentechnik benötigt werden, mit auf dem Substrat integriert werden.

Bei sämtlichen integriert-optischen Ausführungsformen des Lasersenders LS nach den Figuren 2 bis 6 ist ein derartiger Modulator Mod vorgesehen. Beispielsweise kann der Modulator Mod aus zwei Elektroden $El_1$ und $El_2$ bestehen, die auf dem Substrat Str zu beiden Seiten des anderen Wellenleiters WL2 angeordnet sind und an die beispielsweise durch einen Generator G eine modulierende Spannungsdifferenz anlegbar ist, durch welche die in dem anderen Wellenleiter WL2 geführte Ausgangsleistung ASt des Lasersenders modulierbar ist.

Bei der Ausführungsform nach Figur 4 liegt die Besonderheit vor, daß der im Bereich des Richtkopplers RK1 angeordnete Modulator Mod in Reflexion benutzt wird. Dadurch kann bei diesem Sender die Ein- und Auskopplung auf einander gegenüberliegenden Seiten EF1 und EF2 des Substrats erfolgen, im Gegensatz zu den vergleichbaren Ausführungsformen nach den Figuren 2 und 3, wo die Ein- und Auskopplung auf derselben Seite des Substrats erfolgt.

Es sei darauf hingewiesen, daß Modulator- und Kopplerstrukturen bereits auf $LiNbO_3$ realisiert worden sind (siehe dazu beispielsweise J. Lightwave Technol. LT-3 (1985) S. 1-6; J. of Optical Commun. 5 (1984) S. 7-9 oder IEEE J. Quant. Electron. QE-21 (1985) S. 1144-1146).

Im Falle von InGaAsP- oder GaAlAs-Substratmaterial können anstelle der Verspiegelungen Spaltflächen benutzt werden, deren Fertigung gut beherrscht wird.

Bei den integriert optischen Ausführungsformen nach Fig. 5 oder 6 können die Verluste des an den Halbleiterlaser angekoppelten Richtkopplers durch Pumpen der Wellenleiter kleingehalten werden. Ebenso ist eine Abstimmung der emittierten Wellenlänge durch unterschiedliche Pumpströme in den beiden Wellenleitern des Richtkopplers möglich.

Die Modulatoren in den Ausführungsformen nach den Figuren 2 bis 6 können oder Phasen- oder Intensitätsmodulatoren in den üblichen Anordnungen sein (siehe dazu J. Lightwave Technol. LT-3 (1985, S. 1-6; J. of Optical Commun. 5 (1984) S. 7-9; IEEE J. Quant. Electron. QE-21 (1985) S. 1144-1146; ECOC 83 - 9th European Conf. on Optical Commun., H. Melchior, A. Sallberger, Elsevier Science Publishers B.V. (North Holland ) 1983 oder Appl. Phys. Lett. 5 (1985) S. 462-464). Wird ein Phasenmodulator innerhalb des externen Resonators angeordnet, so wird ein frequenzmoduliertes Ausgangssignal erhalten.

Es ist zweckmäßig, die von dem externen Resonator ER abgekehrte Seite des Halbleiterlasers zu verspiegeln. Dadurch steigt die optische Leistung bei gleichem Pumpsystem aufgrund der Schwellstromerniedrigung, und die Empfindlichkeit parasitärer Reflexionen sinkt. Dies gilt für alle Lasersender mit externem Resonator und einseitiger Ankopplung, d.h. bei denen die Ausgangsleistung auf der Seite des Resonators entnommen wird.

## Patentansprüche

1. Lasersender (LS) mit einem Halbleiterlaser (HL) und einem externen optischen Resonator (ER) in Form eines optischen Richtkopplers (RK), der aus zwei in einer bestimmten Koppelstrecke (L) in derart geringem Abstand nebeneinander verlaufenden Wellenleitern (WL1, WL2) besteht, daß in der Koppelstrecke (L) eine Leistungsüberkopplung zwischen den Wellenleitern (WL1, WL2) auftritt, wobei einer (WL1) der beiden Wellenleiter (WL1, WL2) und der Halbleiterlaser (HL) zusammengekoppelt sind, wobei diesem einen Wellenleiter (WL1) eine Rückkopplungseinrichtung (RKE1) zugeordnet ist, die bewirkt, daß wenigstens ein Teil einer ihr aus der Koppelstrecke (L) in dem einen Wellenleiter (WL1) zugeleiteten Strahlungsleistung in diesem einen Wellenleiter (WL1) zurück in die Koppelstrecke (L) geleitet wird, und wobei eine Ausgangsleistung (ASt) des Senders (LS) dem anderen Wellenleiter (WL2) entnehmbar ist, und wobei auch dem anderen Wellenleiter (WL2) eine Rückkopplungseinrichtung (RKE2) zugeordnet ist, die bewirkt, daß wenigstens ein Teil einer ihr aus der Koppelstrecke (L) in dem anderen Wellenleiter (WL2) zugeleiteten Strahlungsleistung in diesem anderen Wellenleiter (WL2) zurück in die Koppelstrecke (L) geleitet wird, und der optische Abstand ($l_1$) zwischen der Koppelstrecke (L) und der dem einen Wellenleiter (WL1) zugeordneten Rückkopplungseinrichtung (RKE1, RKE3) und der optische Abstand ($l_2$)

zwischen der Koppelstrecke (L) und der dem anderen Wellenleiter (WL2) zugeordneten Rückkopplungseinrichtung (RKE2) sich um eine Abstandsdifferenz (△l) voneinander unterscheiden, die betragsmäßig in der Größenordnung einer Länge (ls) des Halbleiterlasers (HL) liegt.

2. Sender nach Anspruch 1, wobei der optische Richtkoppler (RK) ein wellenlängenselektiver Richtkoppler ist.

3. Sender nach einem der vorhergehenden Ansprüche, wobei der Richtkoppler (RK) ein Faserrichtkoppler ist.

4. Sender nach einem der Ansprüche 1 bis 3, wobei der Richtkoppler (RK) ein auf einem Substrat (Str) integrierter Richtkoppler ist.

5. Sender nach Anspruch 4, wobei die beiden Wellenleiter (WL1, WL2) aus auf einem gemeinsamen Substrat (Str) integrierten Streifenwellenleitern bestehen, daß sowohl die dem einen Wellenleiter (WL1) zugeordnete als auch die dem anderen Wellenleiter (WL2) zugeordnete Rückkopplungseinrichtung (RKW1 bzw. RKE2) aus einem auf oder an dem Substrat (Str) fixierten Reflektor (VSp; VSp2 bzw. VSp1; Sp1 bzw. VSp) besteht, bis zu dem der zugeordnete Wellenleiter (WL1 bzw. WL2) heranführt.

6. Sender nach Anspruch 5, wobei ein einem Wellenleiter (WL1, WL2) zugeordneter Reflektor aus einer auf einer Endfläche (EF2, EF1) des Substrats (Str) aufgebrachten Verspiegelung (VSp; VSp2, VSp1) besteht.

7. Sender nach Anspruch 5 oder 6, wobei ein einem Wellenleiter (WL1, WL2) zugeordneter Reflektor aus einem im Bereich des zugeordneten Wellenleiters (WL1, WL2) in das Substrat geätzten Spiegel (Sp1, Sp, Sp2) oder Bragg-Gitter besteht.

8. Sender nach einem der Ansprüche 4 bis 7, wobei der Halbleiterlaser (HL) auf dem Substrat (Str) integriert ist.

9. Sender nach einem der Ansprüche 4 bis 8, wobei auf dem Substrat (Str) ein Modulator (Mod) zur Modulation einer in einem Streifenwellenleiter (WL2, WL3) geführten Strahlunsleistung integriert ist.

10. Sender nach einem der vorhergehenden Ansprüche, wobei Abschnitte der Wellenleiter (WL1, WL2) zwischen der Koppelstrecke (L) und den diesen Wellenleitern (WL1, WL2) zugeordneten Rückkopplungseinrichtungen (RKE1, RKE2) unsymmetrisch zu einer Mittelachse (A) des Wellenleiterpaares (WL1, WL2) innerhalb der Koppelstrecke (L) verlaufen.

## Claims

1. Laser transmitter (LS) having a semiconductor laser (HL) and an external optical resonator (ER) in the form of an optical directional coupler (RK), which comprises two waveguides (WL1, WL2) extending next to one another in a specific coupling section (L) at a distance so small that a power cross-over occurs in the coupling section (L) between the waveguides (WL1, WL2), one (WL1) of the two waveguides (WL1, WL2) and the semiconductor laser (HL) being coupled together, there being assigned to this one waveguide (WL1) a feedback device (RKE1) which has the effect that at least a portion of the radiant power supplied to it from the coupling section (L) in the one waveguide (WL1) is guided back in this one waveguide (WL1) into the coupling section (L), and it being possible to extract the output power (ASt) of the transmitter (LS) from the other waveguide (WL2), and there also being assigned to the other waveguide (WL2) a feedback device (RKE2) which has the effect that at least a portion of the radiant power supplied to it from the coupling section (L) in the other waveguide (WL2) is guided back in this other waveguide (WL2) into the coupling section (L), and the optical section ($l_1$) between the coupling section (L) and the feedback device (RKE1, RKE2) assigned to the one waveguide (WL1) and the optical section ($l_2$) between the coupling section (L) and the feedback device (RKE2) assigned to the other waveguide (WL2) differing from one another by a section difference (△l) which in terms of absolute size is of the order of magnitude of a section (ls) of the semiconductor laser (HL).

2. Transmitter according to Claim 1, wherein the optical directional coupler (RK) is a wavelength-selective directional coupler.

3. Transmitter according to one of the preceding claims, wherein the directional coupler (RK) is a fibre directional coupler.

4. Transmitter according to one of Claims 1 to 3, wherein the directional coupler (RK) is a directional coupler integrated on a substrate (Str).

5. Transmitter according to Claim 4, wherein the two waveguides (WL1, WL2) comprise strip waveguides integrated on a common substrate (Str), and both the feedback device (RKW1 or RKE2) assigned to the one waveguide (WL1) and the feedback device (RKW1 or RKE2) assigned to the other waveguide (WL2) comprise a reflector (VSp; VSp2 or VSp1; Sp1 or VSp) fixed on or to the substrate (Str) and up to which the assigned waveguide (WL1 or WL2) leads.

6. Transmitter according to Claim 5, wherein a reflector assigned to a waveguide (WL1, WL2) comprises a mirror layer (VSp; VSp 2, VSp1) applied to an end face (EF2, EF1) of the substrate (Str).

7. Transmitter according to Claim 5 or 6, wherein a reflector assigned to a waveguide (WL1, WL2) comprises a mirror (Sp1, Sp, Sp2) or Bragg grating etched into the substrate in the region of the assigned waveguide (WL1, WL2).

8. Transmitter according to one of Claims 4 to 7, wherein the semiconductor laser (HL) is integrated on the substrate (Str).

9. Transmitter according to one of Claims 4 to 8, wherein a modulator (Mod) for modulating the radiant power guided in a strip waveguide (WL2, WL3) is integrated on the substrate (Str).

10. Transmitter according to one of the preceding claims, wherein sections of the waveguides (WL1, WL2) between the coupling section (L) and the feedback devices (RKE1, RKE2) assigned to these waveguides (WL1, WL2) extend asymmetrically relative to a centre axis (A) of the pair of waveguides (WL1, WL2) inside the coupling section (L).

**Revendications**

1. Émetteur laser (LS) comportant un laser à semiconducteurs (HL) et un résonateur optique externe (ER) sous la forme d'un coupleur optique directionnel (RK), qui est constitué par deux guides d'ondes (WL1,WL2) qui sont disposés côte-à-côte dans une section de couplage déterminée (L) à une faible distance telle que, dans la section de couplage (L), il apparaît un surcouplage de puissance entre les guides d'ondes (WL1,WL2), dans lequel l'un (WL1) des deux guides d'ondes (WL1,WL2) et le laser à semiconducteurs (HL) sont couplés entre eux, ce guide d'ondes (WL1) étant associé un dispositif de réaction (RKE1), qui agit en sorte qu'au moins une partie d'une puissance de rayonnement qui lui est envoyée à partir de la section de couplage (L) dans ledit guide d'ondes (WL1), est renvoyée dans la section de couplage (L) à l'intérieur de ce guide d'ondes (WL1), et dans lequel une puissance de sortie (ASt) de l'émetteur (LS) peut être prélevée dans l'autre guide d'ondes (WL2), et dans lequel également à l'autre guide d'ondes (WL2) est associé un dispositif de réaction (RKE2), qui agit en sorte qu'au moins une partie d'une puissance de rayonnement, qui lui est envoyée à partir de la section de couplage (L) dans l'autre guide d'ondes (LWL2), est renvoyée à la section de couplage (L) dans cet autre guide d'ondes (WL2), et la distance optique ($l_1$) entre la section de couplage (L) et le dispositif de réaction (RKE1,RKE3) associé au guide d'ondes (WL1), et la distance optique ($L_2$) entre la section de couplage (L) et le dispositif de réaction (RKE2) associé à l'autre guide d'ondes (WL2) diffèrent d'un écart ($\triangle l$), dont la valeur est de l'ordre de grandeur d'une longueur (ls) du laser à semiconducteurs (HL).

2. Émetteur suivant la revendication 1, dans lequel le coupleur optique directionnel (RK) est un coupleur directionnel sélectif pour les longueurs d'ondes.

3. Émetteur suivant l'une des revendications précédentes, dans lequel le coupleur directionnel (RK) est un coupleur directionnel à fibre.

4. Émetteur suivant l'une des revendications 1 à 3, dans lequel le coupleur directionnel (RK) est un coupleur directionnel intégré à un substrat (Str).

5. Émetteur suivant la revendication 4, dans lequel les deux guides d'ondes (WL1,WL2) consistent en des guides d'ondes en forme de bandes, intégrés dans un substrat commun (Str), et dans lequel les dispositifs de réaction (RKW1 ou RKE2) associés ainsi bien au premier guide d'ondes (WL1) qu'à l'autre guide d'ondes (WL2) consistent en des réflecteurs (VSp; VSp2 ou VSp1; Sp1 ou VSp), fixés sur le ou au substrat (Str) et jusqu'auxquelles sont guidés les guides d'ondes associés (WL1 ou WL2).

6. Émetteur suivant la revendication 5, dans lequel un réflecteur associé à un guide d'ondes (WL1,WL2) est constitué par une métallisation (VSp;VSp2,VSp1), qui est déposée sur une surface d'extrémité (EF2,EF1) du substrat (Str).

7.  Émetteur suivant la revendication 5 ou 6, dans lequel un réflecteur associé à un guide d'ondes (WL1,WL2) consiste en un miroir (Sp1,Sp,Sp2) ou un réseau de Bragg, qui est formé par corrosion dans le substrat dans la zone du guide d'ondes associé (WL1,WL2).

8.  Émetteur suivant l'une des revendications 4 à 7, dans lequel le laser à semiconducteurs (HL) est intégré dans le substrat (Str).

9.  Émetteur suivant l'une des revendications 4 à 8, dans lequel un modulateur (Mod) servant à moduler une puissance de rayonnement envoyée dans un guide d'ondes en forme de bande (WL2,WL3), est intégré dans le substrat (Str).

10. Émetteur suivant l'une des revendications précédentes, dans lequel des sections des guides d'ondes (WL1,WL2) entre la section de couplage (L) et les dispositifs de réaction (RKE1,RKE2) associés à ces guides d'ondes (WL1,WL2), sont dissymétriques par rapport à un axe médian (A) du couple de guides d'ondes (WL1,WL2) à l'intérieur de la section de couplage (L).

## FIG 1

## FIG 2

## FIG 3

FIG 4

FIG 5

FIG 6